(19) Europäisches Patentamt
European Patent Office
Office européen des brevets

(11) **EP 1 596 205 B1**

(12) **FASCICULE DE BREVET EUROPEEN**

(45) Date de publication et mention
de la délivrance du brevet:
**28.02.2007   Bulletin 2007/09**

(51) Int Cl.:
***G01R 15/18*** (2006.01)

(21) Numéro de dépôt: **05103759.6**

(22) Date de dépôt: **04.05.2005**

(54) **Transformateur de courant à bobinages de type Rogowski, comportant des circuits partiels associés pour former un circuit complet**

Rogowski-Stromwandler mit zusammengesetzte Teilschaltungen zur Bildung einer Vollschaltung

Rogowski current transformer comprising partial circuits assembled as a full circuit

(84) Etats contractants désignés:
**AT BE BG CH CY CZ DE DK EE ES FI FR GB GR HU IE IS IT LI LT LU MC NL PL PT RO SE SI SK TR**

(30) Priorité: **10.05.2004  FR 0450897**

(43) Date de publication de la demande:
**16.11.2005   Bulletin 2005/46**

(73) Titulaire: **Areva T&D SA**
**92084 Paris-La Défense (FR)**

(72) Inventeurs:
• **Dupraz, Jean-Pierre**
**01360, Bressolles (FR)**
• **Lucot, Lionel**
**69210, Fleurieux sur l'Arbresle (FR)**
• **Chuniaud, Olivier**
**73000, Chambery (FR)**
• **Regnier, Bernard**
**73100, Trevignin (FR)**

(74) Mandataire: **Poulin, Gérard et al**
**Société BREVATOME**
**3, rue du Docteur Lancereaux**
**75008 Paris (FR)**

(56) Documents cités:
**EP-A- 0 573 350          DE-A- 4 424 368**
**DE-A1- 10 161 370**

• **PATENT ABSTRACTS OF JAPAN vol. 2000, no. 08, 6 octobre 2000 (2000-10-06) & JP 2000 147023 A (NIPPON TELEGR & TELEPH CORP < NTT>), 26 mai 2000 (2000-05-26)**

## Description

### DOMAINE TECHNIQUE

L'invention se rapporte à un transformateur de courant qui comporte au moins deux circuits partiels comprenant chacun un bobinage de type Rogowski, ces circuits partiels étant réalisés chacun sous la forme d'une portion angulaire d'un circuit complet qui entoure sur 360° le conducteur primaire du transformateur. Le bobinage de chaque circuit partiel est constitué d'un bobinage aller ainsi que d'un bobinage retour qui parcourent l'étendue angulaire du circuit partiel. Le circuit complet équivaut à un circuit secondaire de type Rogowski du transformateur. Un signal de tension mesuré sur ce circuit secondaire est ainsi proportionnel à la dérivée du courant qui traverse le conducteur primaire.

### ETAT DE LA TECHNIQUE ANTERIEURE

On rappelle qu'une bobine de Rogowski, aussi appelée tore de Rogowski, se présente classiquement sous la forme d'un enroulement conducteur bobiné sur un mandrin de forme torique constitué d'un matériau non ferromagnétique, ce qui lui confère d'excellentes caractéristiques de linéarité dues à l'absence de saturation. Une des difficultés dans la mesure d'un courant primaire au moyen d'un conducteur ou circuit secondaire sous la forme d'une bobine de Rogowski résulte de la variation des paramètres de la bobine avec la température, ce qui peut entraîner des erreurs de mesure importantes. D'autre part, si la bobine n'a pas une parfaite symétrie axiale, la mesure de la dérivée du courant primaire dépend de la position du conducteur primaire traversant le tore ainsi que de son orientation. Il est connu qu'une bonne symétrie axiale exige au minimum que l'enroulement conducteur soit constitué d'un double bobinage, c'est à dire un bobinage enroulé sur un chemin aller suivi d'un bobinage analogue enroulé sur le chemin retour inverse en ayant le même sens d'enroulement des spires sur les deux chemins respectivement aller et retour pour avoir un flux additif des bobinages aller et retour. Ce double bobinage aller et retour permet que la bobine ne soit pas influencée par les champs électromagnétiques produits par des forts courants traversant des conducteurs électriques situés à l'extérieur du tore.

Il est connu de l'état de la technique des transformateurs de courant utilisant des circuits partiels à bobinages de type Rogowski. Le document de brevet DE4424368 divulgue une bobine complète de forme carrée, qui présente une symétrie axiale par rapport au conducteur primaire qui la traverse en son centre. Cette bobine est fabriquée à partir de quatre portions constituées chacune d'un tube recouvert d'une première couche d'un matériau conducteur, la couche étant gravée en hélice pour former une piste constituant un bobinage aller. Ce matériau conducteur est recouvert d'une couche isolante et d'une seconde couche d'un matériau conducteur qui est aussi gravée en hélice pour faire un bobinage retour. Les quatre pistes aller sont reliées en série entre elles par des éléments de connexion joignant les tubes, de même que les quatre pistes retour. La piste complète aller est reliée en série avec la piste complète retour, et la bobine complète aller-retour ainsi réalisée est interrompue en un endroit donné sur un des tubes afin de réaliser les deux terminaisons de sortie aux bornes desquelles la tension induite dans la bobine par le courant primaire peut être mesurée.

Ce principe de constitution d'une bobine de Rogowski complète à partir de bobines partielles sous forme de portions angulaires est aussi appliqué dans les réalisations divulguées par la demande de brevet DE10161370 ou US2003137388A1. Il y est notamment décrit une réalisation dans laquelle la bobine complète est constituée par l'association en série de huit portions de circuits semi annulaires. Chaque portion est constituée par une plaque de circuit imprimé en demi anneau, et un empilement de quatre plaques est réalisé pour former une moitié de bobine qui comporte des moitiés de bobinages aller et retour. Les deux empilements en demi anneaux sont séparables au niveau de deux extrémités angulaires adjacentes afin de faciliter l'installation de la bobine complète autour du conducteur primaire du transformateur. Le raccordement en série du bobinage aller avec le bobinage retour, se situe au niveau d'une première de ces deux extrémités angulaires adjacentes. Les deux terminaisons de sortie de la bobine complète se situent au niveau de la seconde extrémité angulaire qui est adjacente à la première. Il n'y a ainsi pas de raccordement électrique entre ces deux extrémités angulaires adjacentes, tout en ayant un double bobinage aller et retour sur 360° afin de permettre une certaine symétrie axiale de la bobine complète.

Il est connu que la tension $v_s$ mesurée en acquérant (et généralement aussi en amplifiant) le signal de force électromotrice $v_s$ aux bornes d'une bobine de Rogowski qui entoure sur 360° un conducteur primaire dépend de la dérivée temporelle de la mesure algébrique du courant primaire $i_p$ par la relation:

$$v_s(t) = D \cdot S(T) \cdot \frac{\partial i_p}{\partial t}, \qquad (1)$$

dans laquelle S(T) désigne la sensibilité de la bobine à la température T de la mesure, la constante D désignant un facteur d'amplification propre au système d'acquisition de la force électromotrice $v_s$. Le signal $v_s$ est donc indirectement

une image du courant primaire. Dans la suite, on désigne par $S_0$ la sensibilité de la bobine à une température de référence $T_0$ donnée. En outre, si un bobinage de type Rogowski est enroulé sur un tube en arc de cercle, aussi appelé mandrin, qui s'étend sur un secteur angulaire d'un certain angle $\theta$, on peut définir la sensibilité $s_0$ de cette portion de bobinage à la température $T_0$ comme étant égale à $S_0 \times \theta/360$, $\theta$ étant exprimé en degrés, $S_0$ étant la sensibilité de la bobine de Rogowski complète extrapolée en prolongeant le bobinage de façon uniforme sur 360° autour d'un mandrin circulaire. Par exemple, si une bobine complète est constituée par l'association en série de deux portions de bobinages semi annulaires comme montré dans la demande de brevet DE10161370, on peut définir la sensibilité $s_0$ de chaque portion de bobinage comme étant égale à la moitié de la sensibilité $S_0$ de la bobine complète.

Il est cependant à noter qu'avec un bobinage de type Rogowski défini sur un secteur angulaire inférieur à 360°, la mesure du courant d'un conducteur primaire est influencée par la position de ce conducteur par rapport au bobinage, et est à fortiori fortement influencée si ce secteur angulaire est inférieur à 180°. Prenons par exemple le cas d'un bobinage semi annulaire disposé perpendiculairement à un conducteur primaire rectiligne de façon à ce que le conducteur se situe à égale distance des deux extrémités du bobinage. Un déplacement même minime qui tend à éloigner du bobinage le conducteur primaire conduit alors à une diminution sensible de la force électromotrice mesurée aux bornes du bobinage, en supposant un courant primaire uniforme dans le temps. En effet, le champ magnétique généré par le courant primaire en un point donné décroît à mesure que la distance entre ce point et le conducteur primaire augmente. Par conséquent, le flux induit dans le bobinage diminue suite au déplacement précité, et l'image mesurée du courant primaire est ainsi atténuée.

Pour ces raisons, afin de pouvoir obtenir une mesure fiable d'un courant à l'aide d'un bobinage de type Rogowski, il est tout d'abord essentiel que ce bobinage réalise un tour complet du conducteur primaire afin qu'il puisse présenter une parfaite symétrie axiale. En d'autres termes, le bouclage sur 360° du circuit secondaire du transformateur est une des conditions nécessaires pour pouvoir réaliser une mesure indépendante de la position du conducteur primaire par rapport au secondaire. C'est pourquoi dans la littérature relative à ce domaine technique la notion de sensibilité d'un bobinage de type Rogowski n'apparaît généralement que pour un bobinage formant un tore, ou encore pour un ensemble de bobinages mis en série pour réaliser un tour complet. Dans les dispositifs connus de transformateurs de courant utilisant des bobinages formés par des portions d'une bobine de Rogowski complète, tels que par exemple le transformateur montré dans la demande de brevet DE10161370, chaque bobinage est systématiquement relié électriquement en série avec au moins un bobinage analogue formé par une autre portion de bobine afin que l'ensemble de ces portions réalise une bobine de Rogowski complète entourant sur 360° un conducteur primaire.

Dans une réalisation à deux bobinages semi annulaires reliés en série, la sensibilité du bobinage annulaire complet est quasiment égale à celle d'un seul bobinage de mêmes dimensions. De plus, à condition que la liaison en série soit suffisamment courte pour perturber le moins possible l'uniformité des enroulements dans la zone de jonction des deux bobinages, ceci afin de conserver une symétrie axiale quasi parfaite, la mesure peut rester quasiment indépendante de la position du conducteur primaire. Le relatif surcoût qu'implique une telle réalisation à bobinages séparables par rapport à un bobinage classique sur un support fermé peut se justifier notamment par la facilité d'installation du bobinage complet autour du conducteur primaire. Il existe aussi un contexte particulier dans lequel il peut être intéressant de construire une bobine de Rogowski complète à partir de bobines partielles, et sans nécessairement permettre la séparation de deux bobines partielles en vue de faire passer le conducteur primaire dans la boucle de la bobine complète.

Comme connu du document de brevet EP0573350, il est avantageux de réaliser une bobine de Rogowski à partir d'une plaque de circuit imprimé sensiblement carrée et munie d'une découpe circulaire destinée au passage du conducteur primaire. Ce type de bobine présente une parfaite symétrie axiale, et permet d'obtenir un bobinage aller et un bobinage retour avec un grand nombre de spires en ayant un flux additif des bobinages aller et retour, d'où une très bonne sensibilité de la bobine conjuguée avec une très bonne précision de la mesure de l'ordre de 0,1%. La précision reste par ailleurs stable dans le temps en étant quasiment insensible notamment aux vibrations ainsi qu'aux variations de température qui peuvent affecter la bobine. Il est possible en effet d'effectuer une mesure pratiquement indépendante de la température, grâce à l'utilisation d'une résistance en parallèle sur les bornes de sortie de la bobine et dont la valeur est choisie en fonction de divers paramètres de la bobine, ainsi qu'enseigné dans le document de brevet EP0587491.

Les machines de fabrication de plaques de circuits imprimés permettent de produire des plaques dans une certaine gamme de dimensions. A la date de dépôt de la présente demande de brevet, il n'existe apparamment pas de machine permettant d'obtenir des plaques de dimensions supérieures à 700 mm. Même si à l'avenir de telles machines viennent à être développées, le coût de fabrication d'une plaque de grandes dimensions restera à priori supérieur au coût de plusieurs plaques qui seraient assemblées pour former cette grande plaque. Or, certaines mesures de courant par bobine de Rogowski, par exemple dans des lignes ou appareillages électriques blindés isolés au gaz, nécessitent que le diamètre interne de l'anneau qui est formé par les pistes et de trous métallisés de la bobine du secondaire du transformateur soit au moins de l'ordre de cette valeur de 700 mm. Il est à noter que pour de tels diamètres, il est très avantageux de réaliser les bobines dans des plaques de circuits imprimés afin de pouvoir conserver une précision de la mesure dans la classe 0,1%, car les techniques classiques de fabrication de bobine par enroulement d'un conducteur ne permettent pas de produire des bobines atteignant cette classe de précision.

Une solution pour permettre de réaliser de plus grandes bobines en plaques de circuits imprimés consiste à assembler dans un même plan plusieurs plaques sur chacune desquelles sont gravées des portions angulaires de bobinages. Une première méthode de raccordement des portions angulaires d'une bobine complète consiste à les relier électriquement en série via des conducteurs spécialement adaptés pour l'usage, c'est à dire à relier en série les bobinages de même sens aller ou retour au niveau de chaque jointure de deux plaques adjacentes sur le même principe que pour les connexions qui sont réalisées entre les tubes gravés montrés dans le document de brevet DE4424368. On peut par exemple assembler quatre quartiers d'une bobine annulaire complète, chaque quartier étant réalisé à partir d'une plaque carrée de circuit imprimé dont le côté a pour longueur au moins la moitié du diamètre externe de la bobine annulaire. Il est ainsi possible de réaliser des bobines complètes en technologie de circuit imprimé jusqu'à un diamètre externe de l'ordre de 1400 mm, ce qui dépasse les plus grandes dimensions des enveloppes métalliques autour desquelles il est installé des secondaires de transformateurs de courant dans les lignes ou appareillages électriques blindés actuels.

Le circuit secondaire du transformateur de courant réalisé par la bobine annulaire complète peut ainsi être installé à la pression atmosphérique, par exemple autour d'une double virole métallique de raccordement étanche de deux enveloppes métalliques remplies de gaz isolant sous pression et traversées par le conducteur primaire du transformateur. Ce conducteur primaire est par exemple constitué du conducteur d'une ligne blindée monophasée. Les deux viroles sont raccordées mutuellement par un joint d'étanchéité au gaz isolant, ce joint étant réalisé dans un matériau assurant une isolation électrique. Ceci permet que le courant de retour circulant dans les enveloppes métalliques passe à l'extérieur de la bobine annulaire, et ainsi que la mesure de courant ne soit pas influencée par ce courant de retour.

Cependant, la solution consistant à relier électriquement en série les portions angulaires d'une bobine complète peut présenter certains inconvénients, aussi bien dans le cas d'une bobine à enroulement torique classique que dans le cas d'une bobine annulaire en technologie de circuit imprimé. Tout d'abord, une liaison par un pont conducteur qui relie deux portions adjacentes de la bobine complète perturbe dans une certaine mesure l'uniformité de la distribution des enroulements dans la zone de jonction des bobinages. Ceci est particulièrement visible par exemple sur la figure 3 du document de brevet DE10161370. Dans le cas de portions angulaires réalisées par des plaques en quartiers de circuit imprimé, il est nécessaire de prévoir une liaison très courte afin de conserver une uniformité de distribution des enroulements quasi parfaite pour la bobine de Rogowski complète, en vue de maintenir la précision de la mesure dans la classe 0,1%. D'autre part, la zone de jonction électrique et mécanique entre deux quartiers adjacents de circuit imprimé constitue une zone de fragilité du fait des vibrations et dilatations qui affectent ces quartiers. Même en prévoyant un montage des quartiers sur des éléments relativement souples comme des gommes afin de limiter l'amplitude des vibrations et des contraintes aux jointures des quartiers, il est difficile d'éviter le risque d'éventuelles ruptures des ponts conducteurs qui relient les circuits imprimés des quartiers si ces ponts sont prévus rigides, et il est donc généralement nécessaire de prévoir des ponts conducteur souples.

Les difficultés pour obtenir une jonction électrique qui soit mécaniquement fiable entre deux quartiers adjacents de circuit imprimé et qui perturbe le moins possible la mesure peuvent cependant être surmontées, notamment avec la solution d'un pont conducteur souple. Il est ainsi possible d'obtenir une bobine de Rogowski annulaire complète de grande dimension formée par des quartiers de circuit imprimé, et qui est électriquement équivalente à une bobine de même dimension qui serait fabriquée à partir d'une seule plaque de circuit imprimé comme enseigné dans le document de brevet EP0573350, dans l'hypothèse bien sûr où disposerait d'une machine permettant la fabrication d'une plaque d'une telle dimension. Les deux terminaisons électriques de la bobine de Rogowski complète se situent de préférence à une extrémité d'un quartier de bobine à côté de la jointure avec le quartier adjacent, cette jointure étant alors la seule qui n'est pas enjambée par un pont conducteur.

En considérant cette dernière solution à quartiers de bobine de Rogowski, en particulier pour des réalisations en technologie de circuit imprimé telle qu'enseignée par le document de brevet EP0573350, il faut prendre en compte que l'anneau formé par la bobine complète du transformateur de courant peut avoir un diamètre typiquement supérieur à 700 mm dans des applications à des transformateurs de courant pour des appareillages électriques blindés isolés au gaz. Le nombre total de spires (formées chacune par deux segments de pistes opposées et deux trous métallisés d'un circuit imprimé) peut alors être très grand pour la bobine de Rogowski complète. Il convient à ce stade de rappeler que la sensibilité totale $S_0$ d'une bobine de Rogowski de grand diamètre est peu différente de celle d'une bobine de plus petit diamètre mais ayant la même densité de spires. L'accroissement de sensibilité dû au nombre plus élevé de spires est en effet contrebalancé par la plus faible valeur du champ magnétique dû à l'éloignement du bobinage vis à vis du conducteur primaire dont on veut mesurer le courant.

Ainsi, même pour une bobine de grand diamètre, les signaux parasites de surtensions qui peuvent affecter le signal de force électromotrice induit dans la bobine ont des amplitudes relativement importantes du fait que la sensibilité totale $S_0$ est quasiment indépendante du diamètre de la bobine. Les signaux parasites sont causés par des courants en hautes fréquences dans la ligne dont le courant primaire $i_p$ est mesuré par le transformateur. Du fait que le signal de force électromotrice est proportionnel à la dérivée du courant primaire $i_p$, les perturbations en hautes fréquences qui peuvent affecter le courant primaire engendrent inévitablement des surtensions aux bornes du bobinage secondaire du transformateur. Les signaux parasites de surtensions doivent alors être traités par une unité d'acquisition et de traitement apte à produire un signal $v_s$ corrigé (et le plus souvent amplifié) qui est une image du signal d'un courant primaire corrigé dans lequel les perturbations de courant en hautes fréquences auraient été filtrées.

Du fait de leurs amplitudes relativement importantes, les signaux parasites de surtensions peuvent s'avérer difficiles à traiter pour corriger le signal mesuré, ce qui se traduit alors par une moins bonne précision de la mesure. Même dans le cas où un traitement performant de correction du signal est réalisé sur le signal de force électromotrice aux bornes de la bobine de Rogowski en vue d'une très bonne précision de la mesure, ceci implique généralement un surcoût par rapport à l'obtention d'une précision du même ordre dans une situation où les signaux parasites de surtensions ont une moindre amplitude.

L'objectif principal de l'invention est de réaliser un transformateur de courant dont le circuit secondaire comprend une bobine de Rogowski complète de grand diamètre formée à partir de plusieurs portions angulaires de bobine mécaniquement assemblées entre elles, avec une très bonne uniformité de la symétrie axiale de la bobine complète, et tout en ayant une configuration du circuit secondaire du transformateur qui permet de limiter les amplitudes des signaux parasites de surtensions à traiter. Un objectif plus particulier est de parvenir à des réalisations en technologie de circuit imprimé pour des bobines de Rogowski complètes de grand diamètre en faisant l'économie de tout pont conducteur entre les bobinages des circuits imprimés partiels adjacents qui composent la bobine complète, ces réalisations devant permettre d'atteindre au moins une précision dans la classe 0,1% avec une excellente stabilité thermique.

## EXPOSE DE L'INVENTION

A cet effet, l'invention a pour objet un transformateur de courant qui comporte au moins deux circuits partiels comprenant chacun un bobinage de type Rogowski, ces circuits partiels étant réalisés chacun sous la forme d'une portion angulaire d'un circuit complet qui entoure sur 360° le conducteur primaire du transformateur, ledit circuit complet ayant la fonction de circuit secondaire de type Rogowsky pour le transformateur, le bobinage de chaque circuit partiel étant constitué d'un bobinage aller ainsi que d'un bobinage retour qui parcourent l'étendue angulaire du circuit partiel, caractérisé en ce que pour chaque circuit partiel, les bobinages aller et retour sont reliés électriquement en série en ayant un même sens d'enroulement de spires afin de former un seul bobinage qui présente une paire de terminaisons électriques voisines, les paires de terminaisons électriques desdits bobinages étant reliées à un système d'acquisition prévu pour produire un signal complet qui est une image du courant primaire du transformateur

Le circuit complet constitué par l'association d'un nombre N de circuits partiels présente ainsi le même nombre N de paires de terminaisons électriques. Comme expliqué plus loin dans la présente, les signaux de force électromotrice $v_{s(n)}$ mesurés aux bornes de chaque circuit partiel sont transmis à un système d'acquisition sommateur (avec généralement amplification) prévu pour recréer un signal complet $v_s$ qui vérifie, à une température de référence $T_0$ donnée, la relation suivante :

$$v_s(t) = K \cdot \sum_{n=1}^{N} v_{s(n)}(t) = K \cdot S_0 \cdot \frac{\partial i_p}{\partial t}, \qquad (2)$$

où K désigne le facteur d'amplification global du système d'acquisition sommateur et $S_0$ désigne la sensibilité du circuit complet équivalent. Il est expliqué plus loin comment des valeurs de résistances qui déterminent le facteur d'amplification global peuvent être paramétrées pour que ce facteur soit insensible aux variations de la température. Il faut noter que $S_0$ est égale à la sensibilité d'une bobine complète qui serait constituée par la mise en série des bobinages des circuits partiels pour obtenir une configuration équivalente à celle décrite dans le brevet EP0573350, configuration dans laquelle le bobinage complet présente seulement deux terminaisons électriques pour acquérir le signal de force électromotrice image du courant primaire.

Dans un transformateur de courant selon l'invention, et dans le cas où tous les circuits partiels sont identiques, la sensibilité $S_0$ du circuit complet équivalent est égale à la sensibilité $s_0$ d'un circuit partiel multipliée par le nombre N de circuits partiels. La relation (2) précédente peut s'écrire :

$$v_s(t) = K \cdot N \cdot s_0 \cdot \frac{\partial i_p}{\partial t}, \quad \text{soit} \quad \frac{\partial i_p}{\partial t} = v_s(t) / (K \cdot N \cdot s_0), \qquad (3)$$

et il est donc possible de déterminer le courant primaire du transformateur par intégration dans le temps du signal complet $v_s$ mesuré sur le circuit secondaire de type Rogowski.

Préférablement, la paire de terminaisons électriques d'un circuit partiel est disposée à une des deux extrémités angulaires du circuit partiel, les bobinages aller et retour parcourant chacun l'étendue angulaire du circuit partiel en étant électriquement reliés en série au niveau de l'autre extrémité angulaire. Cette disposition des bornes à une extrémité angulaire d'un circuit partiel permet notamment que les bornes de deux circuits partiels adjacents puissent être disposées côte à côte afin d'utiliser deux câbles blindés relativement courts et de mêmes longueurs pour relier les deux circuits à un système d'acquisition de signaux. Il a en effet été constaté qu'il est important que les câbles soient à la fois relativement courts et de mêmes longueurs, pour permettre de limiter à des niveaux n'affectant pas la précision dans la classe 0,1% les signaux parasites qui peuvent être générés au niveau du câblage par les forts champs électromagnétiques dus aux courants circulant dans des conducteurs primaires voisins du transformateur de courant.

Dans un mode de réalisation préféré d'un transformateur de courant selon l'invention, chaque circuit partiel est réalisé par une plaque de circuit imprimé plane ou courbée comportant sur chacune de ses deux faces une série de pistes métalliques, les pistes d'une série étant électriquement reliées avec celles de l'autre série par des trous métallisés traversant la plaque pour former le bobinage du circuit partiel.

Selon un autre mode de réalisation avantageux d'un transformateur de courant selon l'invention, une des deux terminaisons du bobinage de chaque circuit partiel est électriquement reliée à un potentiel de référence commun, tandis que l'autre terminaison est électriquement reliée à une entrée d'un système d'acquisition qui a une fonction d'amplification en comportant au moins un amplificateur opérationnel avec une boucle de réaction. Avantageusement, chaque entrée du système d'acquisition est reliée à une entrée de l'amplificateur opérationnel par l'intermédiaire d'une résistance dont la valeur est choisie pour que le signal de tension mesuré en sortie du système d'acquisition soit indépendant des variations de la température du circuit secondaire du transformateur.

## BREVE DESCRIPTION DES DESSINS

L'invention, ses caractéristiques et ses avantages sont précisés dans la description qui suit en rapport avec les figures ci dessous.

La figure 1 représente schématiquement un circuit partiel d'un transformateur de courant selon l'invention, sous la forme d'un quartier annulaire plan en technologie de circuit imprimé.

La figure 1a représente schématiquement un agrandissement d'une première extrémité angulaire du circuit partiel de la figure 1.

La figure 1b représente schématiquement un agrandissement d'une seconde extrémité angulaire du circuit partiel de la figure 1.

La figure 2 représente schématiquement une vue en perspective d'un transformateur de courant selon l'invention, comprenant un circuit complet en anneau qui est constitué par l'association de quatre circuits partiels formant des quartiers identiques à faces alternées et qui forme le circuit secondaire du transformateur.

La figure 2a représente schématiquement un circuit partiel formant un quartier constitutif du circuit complet de la figure 2.

La figure 2b représente schématiquement une face d'une extrémité angulaire du circuit partiel de la figure 2a, en montrant la série de pistes métalliques de cette face.

La figure 2c représente schématiquement l'autre face de l'extrémité angulaire de circuit partiel représentée sur la figure 2b, avec sa série de pistes métalliques.

La figure 3 représente schématiquement une vue partielle d'un circuit secondaire d'un transformateur de courant selon l'invention, comportant deux circuits complets disposés parallèlement entre eux.

La figure 4 représente schématiquement une vue partielle d'un autre circuit secondaire d'un transformateur de courant selon l'invention.

La figure 5 représente schématiquement une vue partielle d'un autre circuit secondaire d'un transformateur de courant selon l'invention, constitué d'un seul circuit complet dont chaque circuit partiel comporte deux plaques superposées de circuit imprimé.

La figure 5a représente schématiquement une vue de dessus du circuit partiel représenté sur la figure 5 avec son support.

La figure 6 représente schématiquement une vue en perspective d'un transformateur de courant selon l'invention, comprenant un circuit complet en anneau tubulaire qui est constitué par l'association de quatre circuits partiels formant des quartiers identiques.

La figure 6a représente schématiquement les deux faces d'un circuit partiel formant un quartier constitutif du circuit complet de la figure 2.

La figure 7 représente le schéma électrique d'un transformateur de courant selon l'invention qui comprend un circuit complet constitué par l'association de quatre circuits partiels identiques alternés et comprend en outre un système d'acquisition sommateur.

La figure 8 représente le schéma électrique d'un transformateur de courant selon l'invention, comprenant deux circuits complets disposés parallèlement entre eux, et comprenant un système d'acquisition sommateur à deux étages d'amplification.

La figure 9 représente schématiquement un transformateur de courant selon l'invention, appliqué à la détection d'un éventuel courant homopolaire dans une ligne triphasée.

## EXPOSE DETAILLE DE MODES DE REALISATION PARTICULIERS

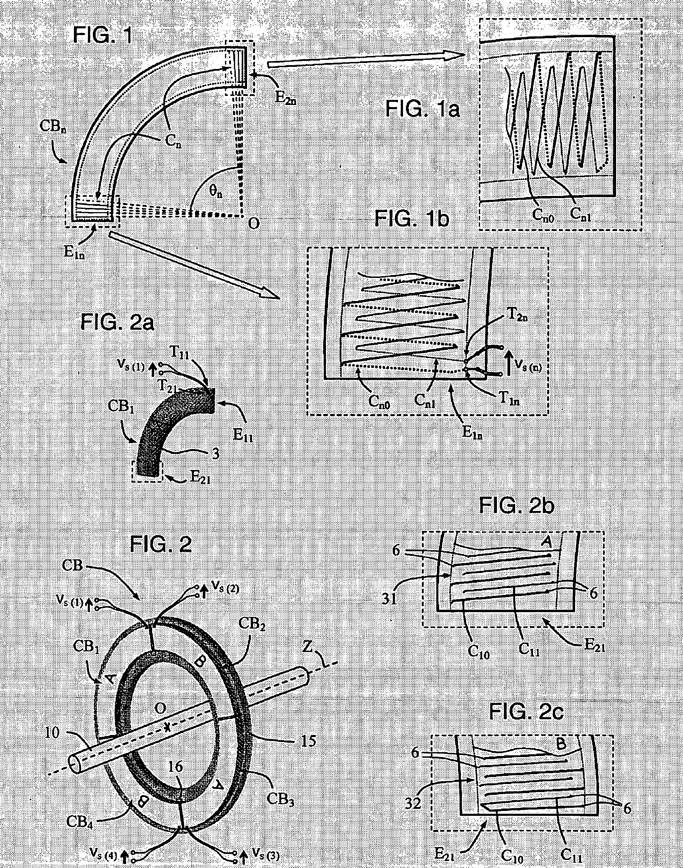

Sur la figure 1, un circuit partiel $CB_n$ pour un transformateur de courant selon l'invention est représenté schématiquement sous la forme d'un quartier annulaire plan en technologie de circuit imprimé. La méthode de réalisation des spires d'un bobinage de Rogowski en circuit imprimé est connue du document de brevet EP0573350, et permet que les pistes métalliques rectilignes qui sont prévues sur les deux faces du circuit imprimé soient disposées selon des rayons dont le prolongement passe par le centre O du quartier annulaire. L'étendue angulaire $\theta_n$ du circuit partiel est ici égale à 90°, de telle sorte qu'un circuit complet peut être formé en associant dans un même plan quatre circuits partiels identiques, pour constituer le conducteur secondaire du transformateur de type Rogowski. Par la suite, nous appellerons circuit secondaire un conducteur secondaire d'un transformateur de courant selon l'invention, en particulier si ce dernier est réalisé en technologie de circuit imprimé. Avec les machines de fabrication de plaques de circuits imprimés actuelles, il est possible de fabriquer un circuit partiel en quartier annulaire jusqu'à une dimension de rayon externe d'environ 500 mm, à partir d'une plaque rectangulaire de circuit imprimé d'environ 700 mm dans sa plus grande dimension.

Un circuit partiel $CB_n$ est donc ici formé par un quartier d'un circuit secondaire annulaire tel que décrit dans le brevet EP0573350. Toutefois, il n'est pas électriquement identique à un quartier qui serait obtenu par une simple découpe du circuit imprimé d'une bobine de Rogowski de l'état de la technique précité. En effet, comme visible sur la figure 1b, chaque circuit partiel $CB_n$ comprend à une première extrémité angulaire $E_{1n}$ une paire de terminaisons électriques voisines $T_{1n}$ et $T_{2n}$ qui constituent les deux extrémités d'un seul bobinage continu $C_n$. Les bobinages respectivement aller $C_{n0}$ et retour $C_{n1}$ qui parcourent l'étendue angulaire du circuit partiel sont électriquement reliés en série au niveau de la seconde extrémité angulaire $E_{2n}$ du circuit afin que le bobinage $C_n$ soit continu entre les deux bornes constituées par les terminaisons $T_{1n}$ et $T_{2n}$. Les pistes métalliques représentées en traits pleins sont formées sur une même face du circuit partiel, tandis que les pistes représentées en traits pointillés sont formées sur l'autre face du circuit.

Comme visible sur les figures 1a et 1b, les deux extrémités angulaires $E_{1n}$ et $E_{2n}$ d'un circuit partiel $CB_n$ pour un transformateur de courant selon l'invention ne comportent pas de pont conducteur pour le raccordement à un autre circuit partiel, puisque le bobinage $C_n$ d'un circuit partiel $CB_n$ est indépendant des bobinages des autres circuits partiels du circuit complet sur 360°. Comme représenté sur la figure 1b, un signal de force électromotrice $v_{s(n)}$ peut être mesuré aux bornes constituées par les deux terminaisons $T_{1n}$ et $T_{2n}$ de chaque circuit partiel.

Par souci de simplification des schémas des figures 1a et 1b, les bobinages respectivement aller $C_{n0}$ et retour $C_{n1}$ sont représentés comme si le bobinage continu $C_n$ était formé par un fil conducteur enroulé autour d'un anneau. Toutefois, cette méthode d'enroulement n'est en réalité pas adaptée à circuit partiel pour un transformateur de courant selon l'invention, même si elle répond à la nécessité de ne pas avoir de croisement de fils entre les bobinages aller et retour. En effet, on peut voir notamment sur la figure 1a que le bobinage aller $C_{n0}$ n'a pas le même sens d'enroulement des spires que le bobinage retour $C_{n1}$. Plus précisément, alors que les spires du bobinage aller $C_{n0}$ progressent dans le sens inverse des aiguilles d'une montre pour un observateur tourné vers la droite de la figure 1a, les spires du bobinage retour $C_{n1}$ progressent dans le sens des aiguilles d'une montre pour le même observateur. Cette méthode d'enroulement ne peut donc permettre un flux additif des bobinages aller et retour, et une autre méthode doit être utilisée pour réaliser le bobinage particulier d'un circuit partiel destiné à un transformateur de courant selon l'invention. Par exemple, en technologie de circuit imprimé, il est possible d'adopter la méthode d'enroulement avec entrelacement des spires aller et retour qui est décrite dans le document de brevet EP0573350, en référence au dessin des pistes métalliques qui est illustré sur la figure 2 de ce document.

Sur la figure 2, un circuit complet CB en anneau, constitué par l'association de quatre circuits partiels en technologie de circuit imprimé, est représenté schématiquement vu en perspective. Ce circuit complet constitue le circuit secondaire d'un transformateur de courant selon l'invention, le conducteur primaire du transformateur étant ici constitué par une barre 10 d'axe Z qui traverse l'anneau de préférence perpendiculairement en son centre O. Les quatre circuits partiels forment des quartiers identiques à faces A et B alternées qui sont montés sur un même cadre annulaire 15 plan de façon à ce que les extrémités angulaires adjacentes des circuits partiels soient maintenues accolées les unes contre les autres. Des attaches 16 ayant des propriétés élastiques de rappel sont prévues pour assurer le maintien entre deux extrémités angulaires adjacentes. Préférablement, le coefficient de dilatation du cadre 15 est sensiblement égal au coefficient de dilatation du substrat des circuits imprimés, de façon à éviter l'apparition d'un jeu ou d'une contrainte excessive entre deux circuits partiels adjacents lors d'une variation de température.

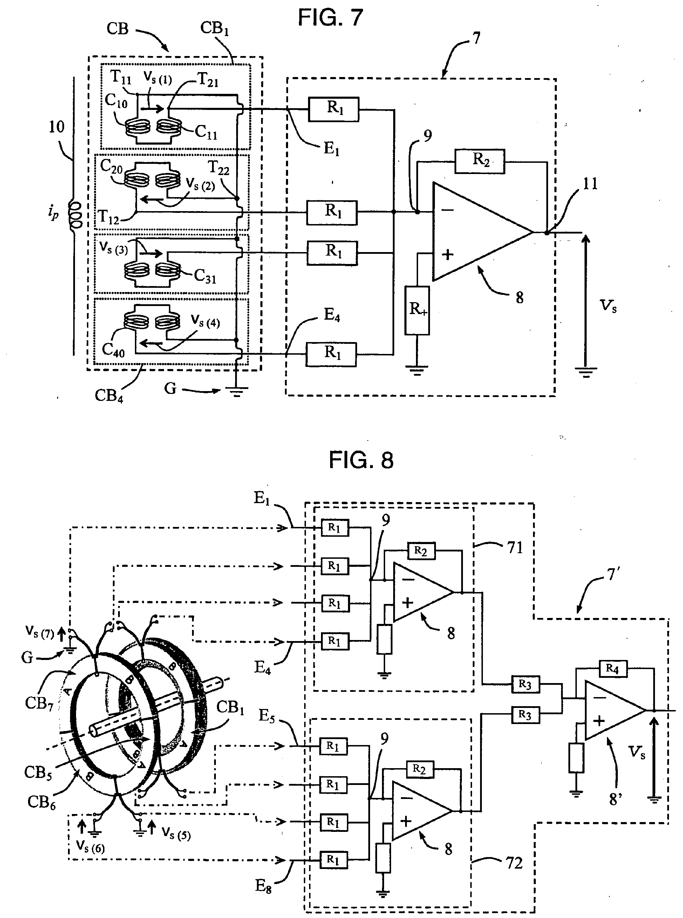

Quatre circuits partiels identiques $CB_1$ à $CB_4$ sont ainsi assemblés sur le cadre annulaire 15, le circuit complet étant maintenu au cadre par exemple grâce à trous circulaires ménagés sur des excroissances radiales de la bordure extérieure des circuits imprimés. Ces trous doivent alors être prévus pour être traversés avec un faible jeu par des plots cylindriques correspondants qui sont fixés au cadre, deux plots cylindriques pouvant suffire pour le montage d'un circuit partiel sur le cadre. Dans cet exemple de réalisation d'un circuit complet en anneau avec des circuits partiels identiques, deux circuits partiels adjacents vus d'un même côté de l'anneau ont des faces A et B alternées, de façon à ce que leurs deux paires de bornes respectives soient disposées côte à côte. L'intérêt de cette disposition est expliqué plus loin en rapport avec le mode de réalisation représenté sur la figure 8.

Le circuit partiel $CB_1$ du circuit complet CB de la figure 2 est représenté schématiquement sur la figure 2a. Les deux bornes $T_{11}$ et $T_{21}$ du circuit imprimé sont disposées ici sur la face A de la couche unique 3 de substrat formant la plaque du circuit, à la première extrémité angulaire $E_{11}$ du quartier annulaire. Ces deux bornes sont séparées d'une distance typiquement de quelques dixièmes de millimètres, de façon à pouvoir être respectivement connectées par exemple par des soudures à deux câbles qui aboutissent à un système d'acquisition pour mesurer la force électromotrice $v_s$ (1) du circuit $CB_1$. De préférence, ces deux bornes consistent en des trous métallisés qui traversent l'épaisseur de la plaque 3 et qui constituent les terminaisons $T_{11}$ et $T_{21}$ du bobinage du circuit partiel $CB_1$. De cette façon, les soudures pour les deux câbles précités peuvent être réalisées sur l'une quelconque des deux faces A et B du circuit. En particulier, le circuit partiel $CB_2$ visible sur la figure 2 est prévu identique au circuit $CB_1$, mais les soudures pour les deux câbles de mesure de la force électromotrice $v_{s(2)}$ du circuit sont réalisées sur sa face B. De cette façon, les paires de câbles des circuits partiels peuvent être toutes situées sur un même côté du circuit complet CB, par exemple sur le côté visible sur la figure 2.

Sur la figure 2b, la face A de la seconde extrémité angulaire $E_{21}$ du circuit partiel $CB_1$ de la figure 2a est représentée schématiquement en montrant la série 31 de pistes métalliques de cette face. Les pistes du bobinage aller $C_{10}$ et celles du bobinage retour $C_{11}$ sont entrelacées et quasiment parallèles entre elles, d'où une densité de pistes qui peut être importante pour permettre une grande sensibilité du bobinage du circuit partiel. La face B de cette seconde extrémité angulaire $E_{21}$, avec sa série 32 de pistes métalliques, est représentée schématiquement sur la figure 2c. Des trous métallisés 6 traversent le substrat du circuit aux extrémités des pistes, permettant de relier entre elles les pistes d'un même bobinage aller $C_{10}$ ou retour $C_{11}$ pour réaliser les spires du bobinage de Rogowski comme décrit dans le document de brevet EP0573350.

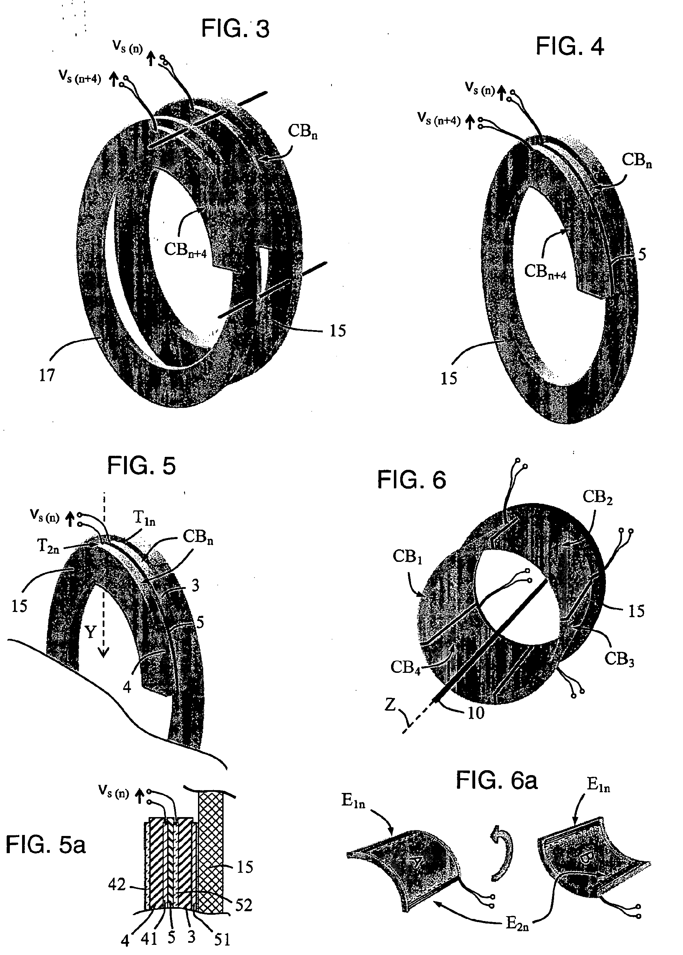

La figure 3 représente schématiquement une vue partielle éclatée d'un circuit secondaire comportant deux circuits complets disposés parallèlement entre eux. Par souci de simplification, seuls les circuits partiels $CB_n$ et $CB_{n+4}$ sont représentés. Sur le même principe que décrit dans le document de brevet EP0573350, en référence au montage de la figure 3 de ce document, il est en effet avantageux de superposer plusieurs bobines de Rogowski de façon à multiplier d'autant la sensibilité du circuit secondaire total. Chaque bobine complète est ici montée de façon à être maintenue par des tiges fixées au cadre annulaire 15. Un écran métallique 17 annulaire est intercalé entre les deux bobines et sert de support de planéité pour le circuit partiel $CB_{n+4}$. Cet écran a un rôle capacitif avec le support principal formé par le cadre annulaire 15 qui est dans ce cas métallique. Les deux cadres métallique 15 et 17 superposés sont maintenus en alignement axial par les tiges fixées au cadre 15. Il est ainsi possible de réaliser un empilement à couches alternées de bobines de Rogowski en circuits imprimés et d'écrans métalliques 17. Avantageusement, une feuille de mylar peut être interposée entre chaque face d'un écran 17 et les circuits imprimés de la bobine complète qui est maintenue plaquée contre la face.

La figure 4 représente schématiquement une vue partielle d'un autre circuit secondaire comportant deux circuits complets disposés parallèlement entre eux. A l'exception des écrans capacitifs qui ont été retirés ici, ce circuit secondaire est électriquement équivalent à celui de la figure 3. Une couche 5 de résine ou d'une autre matière isolante est intercalée entre chaque circuit partiel $CB_n$ et le circuit partiel $CB_{n+4}$ qui lui est superposé, permettant que chaque groupe de circuits partiels superposés forme un empilage de deux plaques de circuit imprimé. La matière de la couche isolante 5 qui sépare les deux plaques doit avoir un coefficient de dilatation voisin ou égal à celui du substrat des plaques, et peut éventuellement avoir une fonction de collage des plaques. Un seul groupe est montré sur la figure, mais il faut comprendre que le circuit secondaire est constitué de quatre groupes de circuits partiels superposés montés sur le même cadre annulaire 15.

La figure 5 représente schématiquement une vue partielle d'un autre circuit secondaire d'un transformateur de courant selon l'invention, constitué ici d'une seule bobine complète. Chaque circuit partiel de la bobine complète comporte deux quartiers superposés de circuits imprimés séparés par une couche d'une matière isolante 5. Chaque plaque 3 ou 4 qui forme un quartier est ici gravée de façon à ce que le bobinage formé par le circuit imprimé de la plaque soit constitué d'un unique bobinage aller ou retour. Par exemple, si le bobinage aller est gravé sur la plaque 3 en partant de la borne constituée par la terminaison $T_{1n}$ à une extrémité angulaire du quartier, une liaison électrique est alors réalisée à l'extrémité angulaire opposée pour relier le bobinage retour qui est gravé sur la plaque 4. Les pistes du bobinage retour doivent être dessinées de façon à ce que que le sens d'enroulement des spires soit le même que dans le bobinage aller, pour que les flux respectifs des bobinages aller et retour s'ajoutent. La borne $T_{2n}$ du bobinage retour peut être située très proche de la borne $T_{1n}$ , séparée par l'épaisseur de la couche isolante 5. De préférence, cette épaisseur est limitée à quelques dixièmes de millimètres.

Une vue de dessus de ce circuit partiel, orientée selon la direction Y représentée par la flèche en pointillée, est représentée schématiquement sur la figure 5a. De façon connue en soi, les deux séries respectivement 41 et 42 de pistes gravées sur les deux faces de la plaque 4 sont reliées entre elles par des trous métallisés réalisés dans l'épaisseur de la plaque. Il en est de même pour les deux séries respectivement 51 et 52 de pistes gravées sur les deux faces de la plaque 3. L'épaisseur de la couche isolante 5 est préférablement inférieure à l'épaisseur d'une plaque 3 ou 4.

La figure 6 représente une vue en perspective d'un autre transformateur de courant selon l'invention, avec une géométrie particulière. Le secondaire du transformateur est formé par un circuit complet en anneau tubulaire qui est constitué par l'association de quatre circuits partiels formant des quartiers identiques, ce circuit complet étant fixé à un cadre annulaire 15. Chaque plaque de circuit imprimé est ainsi courbée pour avoir la forme d'une portion angulaire d'un anneau tubulaire dont l'axe de symétrie coïncide sensiblement avec l'axe Z du conducteur primaire 10 du transformateur. Comme visible sur la figure 6a, les pistes métalliques de chaque face A ou B d'un circuit partiel sont parallèles à cet axe de symétrie. Chaque extrémité angulaire $E_{1n}$ ou $E_{2n}$ d'un circuit partiel se situe au niveau d'un bord rectiligne de la plaque courbée qui forme ce circuit.

Le schéma électrique d'un transformateur de courant selon l'invention est représenté sur la figure 7. Le transformateur correspond par exemple à celui représenté sur la figure 2, et comprend un circuit secondaire complet CB constitué par l'association de quatre circuits partiels identiques à faces alternées. Le circuit secondaire du transformateur est électriquement relié à un système d'acquisition 7 qui a ici la double fonction de sommation et d'amplification et qui comporte pour ceci un amplificateur opérationnel 8 avec une boucle de réaction. Pour chaque circuit partiel $CB_n$, une des deux bornes $T_{1n}$ ou $T_{2n}$ du bobinage est reliée à un potentiel de référence commun G, tandis que l'autre borne est électriquement reliée à une entrée $E_n$ du système d'acquisition 7.

Par exemple, la borne $T_{11}$ du circuit partiel $CB_1$ est reliée à une masse au potentiel de la terre, et l'autre borne $T_{12}$ est reliée à une résistance $R_1$ en entrée du système d'acquisition 7. Comme représenté schématiquement sur la figure par des enroulements, le bobinage de chaque circuit partiel $CB_n$ doit avoir le même sens d'enroulement des spires sur les deux chemins respectivement aller et retour pour avoir un flux additif des bobinages aller $C_{n0}$ et retour $C_{n1}$. Il est visible qu'en progressant par exemple de la borne $T_{11}$ vers la borne $T_{12}$, le bobinage aller $C_{10}$ et le bobinage retour $C_{11}$ ont le même sens d'enroulement des spires dans le sens inverse des aiguilles d'une montre.

Avantageusement, les deux bornes $T_{1n}$ et $T_{2n}$ d'un circuit partiel sont reliées l'une à une masse et l'autre à une des entrées $E_1$ à $E_4$ du système d'acquisition 7 de façon alternée par rapport aux deux bornes $T_{1n+1}$ et $T_{2n+1}$ d'un circuit partiel adjacent. De cette façon, les signaux des tensions de sortie $v_{s(1)}$ à $v_{s(4)}$ des circuits partiels sont sommés en phase par le système d'acquisition. En effet, il est important que ces signaux ne soient pas sommés en opposition de phase, car le signal de tension $v_s$ mesuré à la borne de sortie 11 du système d'acquisition serait alors sensiblement nul. Du fait que les circuits partiels sont assemblés comme sur la figure 2 avec leurs faces alternées deux à deux, il est nécessaire dans cette configuration d'alterner la polarité des branchements des bornes des circuits partiels aux entrées du système d'acquisition. Une sommation de signaux de tension en phase est ainsi appliquée sur l'entrée inverseuse 9 de l'amplificateur opérationnel 8.

Le principe de sommation et d'amplification illustré par le schéma de la figure 7 peut aussi s'appliquer dans le cas où le transformateur de courant comporte un certain nombre p de circuits complets disposés parallèlement entre eux. Une telle disposition des circuits complets a été expliquée précédemment dans la description relative aux figures 3 et 4. L'entrée 9 de l'amplificateur opérationnel 8 est reliée par l'intermédiaire d'une résistance $R_1$ à une borne de chacun des circuits partiels $CB_n$ qui composent les p circuits complets. Si chaque circuit complet comporte quatre circuits partiels, il y a quatre fois p résistances $R_1$ en entrée du système d'acquisition 7.

Comme démontré dans ce qui suit, le signal $v_s$ mesuré en sortie du système d'acquisition 7 est indépendant des variations de la température si la valeur $R_1$ de chaque résistance à l'entrée du système d'acquisition 7 vérifie la relation (9) ci-après.

On a vu que la sensibilité s d'un circuit partiel se définit telle que que le signal de force électromotrice $v_s$ mesuré

aux bornes d'un circuit partiel vérifie la relation:

$$v_s = s \cdot \frac{\partial i_p}{\partial t} \qquad\qquad (4)$$

D'autre part, la résistance interne r du bobinage d'un circuit partiel varie linéairement avec la température T du circuit partiel selon la relation suivante bien connue en soi:

$$r = r_0 (1 + \beta \cdot \delta T), \qquad\qquad (5)$$

avec $\delta T = T - T_0$, $\beta$ étant le coefficient de température de la résistivité du matériau du bobinage et $T_0$ étant la température de référence. Par exemple, si ce matériau est du cuivre, $\beta$ est de l'ordre de 3900 ppm/°C.

De la même façon, la sensibilité s d'un circuit partiel varie linéairement avec la température T du substrat, puisque une dilatation du substrat provoque une augmentation de la section des spires du circuit partiel, cette section étant proportionnelle à l'épaisseur du substrat. La relation s'écrit:

$$s = s_0 (1 + \alpha_z \cdot \delta T), \qquad\qquad (6)$$

$\alpha_z$ étant le coefficient de dilatation linéaire du substrat selon la direction perpendiculaire à la surface du substrat. Dans l'exemple de réalisation illustré sur la figure 2, cette direction correspond à l'axe Z. Le coefficient $\alpha_z$ est typiquement compris entre 40 et 60 ppm/°C selon les matériaux.

Le courant sur l'entrée inverseuse 9 de l'amplificateur opérationnel 8 étant nul en considérant l'amplificateur idéal, la loi de Kirchoff conduit à la relation suivante:

$$\sum_{n=1}^{N} [v_{s(n)} / (r_{(n)} + R_1)] + v_s / R_2 = 0,$$

où N est le nombre de circuits partiels.
Compte tenu de la relation (4), on obtient: $v_s = -R_2$

$$\cdot \sum_{n=1}^{N} [s_{(n)} \cdot \frac{\partial i_p}{\partial t} / (r_{(n)} + R_1)] \qquad\qquad (7)$$

Les N circuits partiels étant supposés identiques et ayant une même température T, on peut considérer que ces bobinages ont tous la même résistance interne r et la même sensibilité s qui vérifient respectivement les relations (5) et (6) à cette température T. La relation (7), devient donc:

$$v_s = -R_2 / [r_0 (1 + \beta \cdot \delta T) + R_1] \cdot N \cdot s \cdot \frac{\partial i_p}{\partial t},$$

soit

$$\text{soit } v_s = -R_2 / [(r_0 + R_1)[1+ r_0 \cdot \beta \cdot \delta T/_{(r_0 + R_1)}]]$$

$$\cdot N \cdot s_0 \cdot (1+ \alpha_z \cdot \delta T) \cdot \frac{\partial i_p}{\partial t} \,,$$

ou encore

$$\text{soit } v_s = -R_2 / [(r_0 + R_1)[1+ r_0 \cdot \beta \cdot \delta T/_{(r_0 + R_1)}]]$$

$$\cdot N \cdot s_0 \cdot (1+ \alpha_z \cdot \delta T) \cdot \frac{\partial i_p}{\partial t} \,,$$

$$\text{ou encore} \quad v_s = -R_2/(r_0 + R_1) \cdot S_0 \cdot \frac{\partial i_p}{\partial t} \cdot (1+ \alpha_z \cdot \delta T)$$

$$/[1+ r_0 \cdot \beta \cdot \delta T /_{(r_0 + R_1)}] \tag{8}$$

On peut remarquer que si la valeur de $R_1$ est choisie de façon à vérifier la relation:

$$\alpha_z = \beta \cdot r_0 /_{(r_0 + R_1)} \,,$$

soit aussi

$$R_1 = r_0 (\beta/_{\alpha_z} -1) \,, \tag{9}$$

alors la relation (8) s'écrit:

$$v_s = -R_2 / (r_0 + R_1) \cdot S_0 \cdot \frac{\partial i_p}{\partial t} \tag{10}$$

Ainsi, en rapport avec la relation (2), le facteur d'amplification global K du système d'acquisition sommateur 7 vérifie la relation:

$$K = -R_2 / (r_0 + R_1) \,, \tag{11}$$

ou encore, en remplaçant $R_1$ en fonction de la relation (9):

$$K = -R_2 \alpha_z / r_0 \beta$$

Dans l'absolu, les résistances $R_1$ et $R_2$ ne sont pas rigoureusement stables avec les variations de la température. Mais en pratique, d'une part le coefficient de température de chaque résistance peut être choisi très petit (par exemple inférieur à 5 ppm/°C pour une résistance NiCr), et d'autre part les variations infimes des valeurs respectives de $R_1$ et $R_2$ en fonction de la température sont conjointes dans le même sens, de telle sorte que le rapport $R_2 / (r_0 + R_1)$ peut être considéré parfaitement stable avec la température. Le facteur K, et donc le signal $v_s$ mesuré, est ainsi indépendant des variations de la température. Le signal $v_s$ est donc une image très précise du courant $i_p$ du conducteur primaire 10.

La figure 8 représente le schéma électrique d'un transformateur de courant selon l'invention, dans lequel deux circuits complets sont disposés parallèlement entre eux comme expliqué précédemment dans la description relative aux figures 3 et 4. Chaque circuit complet est conforme au circuit décrit en rapport avec la figure 2. Il est entendu que le principe qui est illustré pour le raccordement électrique entre le circuit secondaire et le système d'acquisition sommateur du transformateur peut être appliqué à un nombre p de circuits complets supérieur à deux.

Le système d'acquisition sommateur 7' comprend deux étages d'amplification. Un premier étage d'amplification comprend ici deux amplificateurs opérationnel 8 qui gèrent chacun la moitié des signaux de force électromotrice $v_{s(n)}$ des circuits partiels. Le premier étage d'amplification est ainsi constitué de deux sous ensembles amplificateurs 71 et 72 identiques et chacun analogue au circuit du système d'acquisition 7 de la figure 7. La sortie de chaque amplificateur 8 du premier étage est reliée à un second étage de sommation prévu pour produire le signal complet ($v_s$) image du courant primaire. Ce second étage comprend un amplificateur opérationnel 8' avec une boucle de réaction pour effectuer une amplification de la somme des signaux produits par le premier étage d'amplification.

L'intérêt principal de ce système d'acquisition 7' est lié à la disposition des bornes des circuits partiels du transformateur de courant. En effet, quelque soit le nombre p de circuits complets, on obtient deux groupes de bornes diamétralement opposés. Par exemple, les bornes des circuits partiels $CB_1$, $CB_2$, $CB_5$ et $CB_6$ sont proches les unes des autres et forment le premier groupe, et les bornes des circuits partiels restants forment le second groupe diamétralement opposé. Chaque groupe de bornes est électriquement relié à un sous ensemble amplificateur 71 ou 72, et la longueur des câbles de même longueur constituant le câblage peut être particulièrement courte si chaque sous ensemble 71 ou 72 est disposé à côté de son groupe de bornes. Un blindage efficace de chaque câble ainsi que de chaque sous ensemble amplificateur affectés à un groupe de bornes est alors réalisable sans difficulté majeure, afin que les deux groupes de signaux $v_{s(n)}$ respectivement aux entrées $E_1$ à $E_4$ et $E_5$ à $E_8$ du système d'acquisition 7' ne soient pas perturbés par les champs électromagnétiques dus aux courants circulant dans des conducteurs primaires voisins du transformateur de courant.

Les signaux $v_{71}$ et $v_{72}$ produits par le premier étage d'amplification vérifient les relations :

$$v_{71} \;=\; -R_2 \cdot \sum_{n=3,4,7,8} \left[ s_{(n)} \cdot \frac{\partial i_p}{\partial t} / (r + R_1) \right] \tag{12}$$

$$v_{72} \;=\; -R_2 \cdot \sum_{n=1,2,5,6} \left[ s_{(n)} \cdot \frac{\partial i_p}{\partial t} / (r + R_1) \right] \tag{13}$$

Le signal complet $v_s$ vérifie la relation :

$$v_s \;=\; -R_4/R_3 \cdot (v_{71} + v_{72}) = R_4 \cdot R_2 / [R_3 (r + R_1)] \cdot \left[ \sum_{n=1}^{4} s_{(n)} + \sum_{n=5}^{8} s_{(n)} \right] \cdot \frac{\partial i_p}{\partial t} \,,$$

soit

$$\text{soit } v_s \;=\; R_4 \cdot R_2 / R_3 (r + R_1) \cdot 2 S \cdot \frac{\partial i_p}{\partial t} \tag{14}$$

Sachant que la sensibilité S d'un circuit complet et la résistance interne r d'un circuit partiel vérifient respectivement les relations:

$$S = S_0 (1 + \alpha_z . \delta T) \quad \text{et} \quad r = r_0 (1 + \beta . \delta T),$$

on peut de nouveau choisir $R_1$ de façon à vérifier la relation (9), afin que la tension $v_s$ de sortie du système d'acquisition 7' soit indépendante de la température T des circuits complets.

La relation (14) devient:

$$v_s \;=\; R_4 \,/R_3\,(r_0\,+R_1)\;\cdot\;R_2\;\cdot\;2\;S_0\;\cdot\;\frac{\partial i_p}{\partial t}$$

Les résistances $R_3$ et $R_4$ peuvent être choisies identiques, de façon à ce que le second étage d'amplification effectue une simple sommation des tensions de sortie des deux premiers étages 71 et 72. La relation précédente s'écrit alors :

$$v_s \;=\; 2\;R_2\,/(r_0\,+R_1)\;\cdot\;S_0\;\cdot\;\frac{\partial i_p}{\partial t} \qquad\qquad (15)$$

La comparaison des relations (10) et (15) traduit bien le fait que la sensibilité équivalente à deux circuits complets identiques montés en parallèle est égale à deux fois la sensibilité $S_0$ d'un circuit complet. En outre, l'intérêt d'avoir une pluralité de circuits complets disposés parallèlement entre eux est aussi de permettre une augmentation du rapport signal sur bruit pour le signal $v_s$ de sortie du système d'acquisition. En effet, le rapport signal sur bruit pour un nombre p de circuit complets identiques est $\sqrt{p}$ fois supérieur au rapport signal sur bruit pour un seul circuit complet.

Il n'est pas indispensable d'utiliser des amplificateurs opérationnels pour un système d'acquisition du signal fourni par le circuit secondaire d'un transformateur de courant selon l'invention. La sensibilité de chaque circuit partiel du circuit secondaire peut s'avérer suffisante pour obtenir un signal de tension $v_{s(n)}$ satisfaisant aux bornes d'une résistance $R_1$ qui vérifie la relation (9) et qui relie entre elles les deux terminaisons électriques voisines $T_{1n}$ et $T_{2n}$ du circuit partiel. Les N signaux $v_{s(n)}$ peuvent alors être acquis séparéments et acheminés chacun vers un système de sommation (avec ou sans amplification) pour recréer le signal secondaire du circuit complet formé par les N circuits partiels. Par exemple, chaque signal de tension $v_{s(n)}$ aux bornes d'une résistance $R_1$ peut être acquis par un convertisseur analogique/digital, le signal numérique étant acheminé par voie optique vers un système de sommation pouvant être situé à l'écart du circuit secondaire.

Il est par ailleurs possible de se passer de l'amplificateur opérationnel 8' dans le second étage amplificateur/ sommateur du système d'acquisition 7' représenté sur la figure 7. On peut en effet prévoir un convertisseur analogique/ digital en sortie de chacun des deux sous ensembles amplificateurs 71 et 72 du premier étage amplificateur, et une transmission par exemple par voie optique des deux signaux numériques vers un système de sommation numérique pour recréer le signal $v_s$.

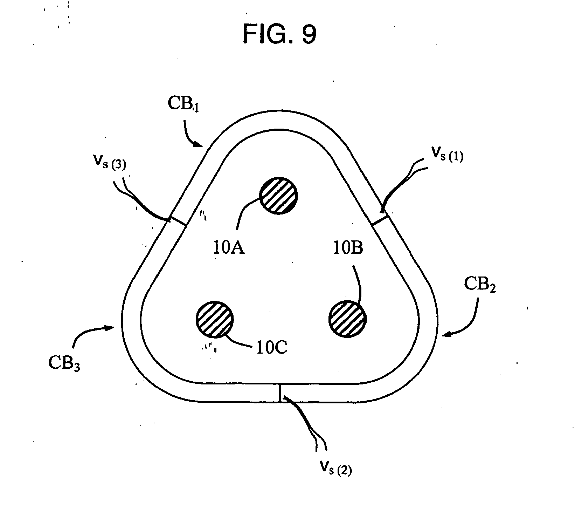

Un transformateur de courant selon l'invention peut aussi être destiné à la détection d'un éventuel courant homopolaire. La figure 9 représente schématiquement un transformateur dont le circuit secondaire est formé par l'assemblage de trois circuits partiels pour entourer trois conducteurs primaires 10A, 10B et 10C d'une ligne triphasée. Les trois tensions de sortie $v_{s(1)}$ à $v_{s(3)}$ des circuits partiels $CB_1$ à $CB_3$ doivent être sommées en phase par un système d'acquisition afin d'obtenir une image d'un courant primaire $i_p$ total ou courant homopolaire qui est en fait la somme vectorielle des trois courants des trois conducteurs primaires. En l'absence de courant de défaut, cette somme vectorielle est nulle, et la sortie du système d'acquisition produit donc un signal de tension sensiblement nul. Par contre, en cas d'apparition d'un défaut à la terre, la somme vectorielle n'est plus nulle et le système d'acquisition permet alors d'avoir une image du courant homopolaire. Bien que la précision de la mesure soit moins bonne qu'avec une bobine complète en anneau circulaire comme décrit précédemment, elle peut sans difficulté être suffisante du fait qu'une mesure de courant homopolaire sert généralement à déclencher une protection. Il n'est pas nécessaire dans ce cas d'avoir une précision de la mesure dans la classe 0,1%.

**Revendications**

**1.** Transformateur de courant comportant au moins deux circuits partiels ($CB_1$, $CB_2$,...$CB_n$..., $CB_N$) comprenant chacun un bobinage ($C_1$, $C_2$, ...$C_n$..., $C_N$) de type Rogowski, lesdits circuits partiels étant réalisés chacun sous la forme d'une portion angulaire d'un circuit complet (CB) qui entoure sur 360° au moins un conducteur primaire (10 , 10A, 10B, 10C) du transformateur, ledit circuit complet ayant la fonction de circuit secondaire de type Rogowski pour le transformateur, le bobinage ($C_n$) de chaque circuit partiel ($CB_n$) étant constitué d'un bobinage aller ($C_{n0}$) ainsi que

d'un bobinage retour ($C_{n1}$) qui parcourent l'étendue angulaire ($\theta_n$) du circuit partiel ($CB_n$), **caractérisé en ce que** pour chaque circuit partiel ($CB_n$), lesdits bobinages aller ($C_{n0}$) et retour ($C_{n1}$) sont reliés électriquement en série en ayant tous deux un même sens d'enroulement de spires afin de former un seul bobinage ($C_n$) qui présente une paire de terminaisons électriques ($T_{1n}$, $T_{2n}$) voisines, les paires de terminaisons électriques ($T_{1n}$, $T_{2n}$) desdits bobinages ($C_n$) étant reliées à un système d'acquisition (7, 7') prévu pour produire un signal complet ($v_s$) qui est une image du courant primaire ($i_p$) du transformateur.

2. Transformateur de courant selon la revendication 1, dans lequel une paire de terminaisons électriques ($T_{1n}$, $T_{2n}$) d'un circuit partiel ($CB_n$) est disposée à une des deux extrémités angulaires ($E_{1n}$, $E_{2n}$) du circuit partiel, les bobinages aller ($C_{n0}$) et retour ($C_{n1}$) parcourant chacun l'étendue angulaire ($\theta_n$) du circuit partiel ($CB_n$) en étant électriquement reliés en série au niveau de l'autre extrémité angulaire du circuit partiel.

3. Transformateur de courant selon l'une des revendications 1 et 2, dans lequel chaque circuit partiel ($CB_1$, $CB_2$, ..., $CB_N$) est réalisé par une plaque de circuit imprimé plane ou courbée comportant sur chacune de ses deux faces une série (31, 32) de pistes métalliques, les pistes d'une série (31) étant électriquement reliées avec celles de l'autre série (32) par des trous métallisés (6) traversant ladite plaque pour former le bobinage ($C_n$) dudit circuit partiel ($CB_n$).

4. Transformateur de courant selon la revendication 3, dans lequel ladite plaque de circuit imprimé comporte une couche de substrat d'épaisseur constante séparant deux séries (31, 32) de pistes métalliques, une première moitié des pistes de chaque série étant utilisée pour le bobinage aller ($C_{n0}$) tandis que l'autre moitié est utilisée pour le bobinage retour ($C_{n1}$) du circuit partiel.

5. Transformateur de courant selon l'une des revendications 1 et 2, dans lequel chaque circuit partiel ($CB_1$, $CB_2$, ..., $CB_N$) est réalisé à partir de deux plaques (3, 4) d'un substrat, chaque plaque comportant sur chacune de ses deux faces une série (41, 42 ; 51, 52) de pistes métalliques, les pistes d'une série (41; 51) sur une plaque étant électriquement reliées avec celles de l'autre série (42; 52) sur la même plaque par des trous métallisés pour former soit un bobinage aller ($C_{n0}$) soit un bobinage retour ($C_{n1}$) dudit circuit partiel ($CB_n$).

6. Transformateur de courant selon la revendication 4, dans lequel chaque circuit partiel ($CB_1$, $CB_2$, ..., $CB_N$) a la forme d'une portion angulaire d'un anneau plan afin de former un circuit complet (CB) en anneau, et chaque série de pistes métalliques (31, 32) d'un circuit imprimé est réalisée avec des pistes sensiblement rectilignes selon des rayons dont le prolongement passe par un axe (Z) perpendiculaire à l'anneau en son centre (O).

7. Transformateur de courant selon la revendication 4, dans lequel chaque plaque de circuit imprimé a la forme d'une portion angulaire d'un anneau tubulaire dont l'axe de symétrie coïncide avec l'axe (Z) du conducteur primaire du transformateur, et dans lequel les pistes métalliques d'un circuit imprimé sont parallèles audit axe (Z) du conducteur primaire.

8. Transformateur de courant selon la revendication 4, dans lequel le circuit complet est monté sur un cadre (15) plan qui est traversé perpendiculairement par au moins un conducteur primaire (10) du transformateur, et dans lequel des attaches (16) ayant des propriétés élastiques de rappel sont prévues pour maintenir accolées les unes contre les autres les extrémités angulaires adjacentes des circuits imprimés.

9. Transformateur de courant selon la revendication 6 prise en combinaison avec la revendication 2, dans lequel le circuit complet (CB) en anneau est formé par au moins quatre circuits partiels ($CB_1$, $CB_2$, $CB_3$, $CB_4$) identiques dont les faces (A, B) d'un même côté de l'anneau sont alternées deux à deux, de façon à ce que qu'une paire de terminaisons électriques ($T_{1n}$, $T_{2n}$) du bobinage d'un premier circuit partiel soit disposée à côté d'une autre paire de terminaisons électriques d'un des deux circuits partiels adjacents audit premier circuit partiel.

10. Transformateur de courant selon l'une des revendications précédentes, dans lequel pour chaque circuit partiel ($CB_n$), une des deux terminaisons électriques ($T_{1n}$, $T_{2n}$) du bobinage est électriquement reliée à un potentiel de référence commun (G), tandis que l'autre terminaison est électriquement reliée à une entrée ($E_n$) d'un système d'acquisition (7, 7') qui a une fonction de sommation et d'amplification en comportant au moins un amplificateur opérationnel (8).

11. Transformateur de courant selon la revendication 10, dans lequel les circuits partiels ($CB_n$) sont identiques, et chaque entrée ($E_n$) du système d'acquisition (7, 7') est reliée à une entrée (9) dudit amplificateur opérationnel (8) par l'intermédiaire d'une résistance dont la valeur $R_1$ est choisie pour vérifier la relation:

$$R_1 = r_0 \ (\beta/\alpha_z - 1)$$

$\alpha_z$ étant le coefficient de température de la sensibilité ($s_n$) de la bobine de Rogowski formée par ledit bobinage ($C_n$), $\beta$ étant le coefficient de température de la résistivité du matériau composant le bobinage ($C_n$) d'un circuit partiel ($CB_n$), et $r_0$ étant la résistance interne dudit bobinage ($C_n$) à une température de référence ($T_0$) donnée, de façon à ce que le signal du circuit complet (CB), une fois amplifié par le système d'acquisition (7, 7'), soit indépendant des variations de la température (T) du transformateur.

12. Transformateur de courant selon l'une des revendications 10 et 11, dans lequel les signaux des tensions de sortie ($v_{s(n)}$) des circuits partiels sont sommés en phase par le système d'acquisition (7, 7').

13. Transformateur de courant selon l'une des revendications précédentes, **caractérisé en ce qu**'il comporte une pluralité (p) de circuits complets (CB) disposés parallèlement entre eux.

14. Transformateur de courant selon la revendication 13 en combinaison avec l'une des revendications 11 et 12, dans lequel le système d'acquisition (7) comporte un circuit d'amplification qui comprend un amplificateur opérationnel (8) dont une entrée (9) est reliée à chacun des circuits partiels ($CB_n$) qui composent les circuits complets (CB).

15. Transformateur de courant selon la revendication 13 en combinaison avec l'une des revendications 11 et 12, dans lequel le système d'acquisition (7') comporte un premier étage d'amplification (71, 72) qui comprend au moins deux amplificateurs opérationnel (8), la sortie de chaque amplificateur (8) dudit premier étage étant reliée à un second étage de sommation prévu pour produire ledit signal complet ($v_s$).

16. Transformateur de courant selon la revendication 15, dans lequel le second étage de sommation comprend un amplificateur opérationnel (8') avec une boucle de réaction pour effectuer une amplification de la somme des signaux produits par le premier étage d'amplification.

## Claims

1. A current transformer comprising at least two partial circuits ($CB_1$, $CB_2$, ..., $CB_n$, ..., $CB_N$) each comprising a Rogowski type winding ($C_1$, $C_2$, ..., $C_n$, ..., $C_N$), each of said partial circuits being made in the form of an angular portion of a complete circuit (CB) which surrounds at least one primary conductor (10, 10A, 10B, 10C) of the transformer over 360°, said complete circuit having the function of a Rogowski type secondary circuit for the transformer, the winding ($C_n$) of each partial circuit ($CB_n$) being constituted by a go winding ($C_{n0}$) together with a return winding ($C_{n1}$) extending over the angular extent ($\theta_n$) of the partial circuit ($CB_n$), **characterized in that** for each partial circuit ($CB_n$), said go and return windings ($C_{n0}$, $C_{n1}$) are electrically connected in series, both having turns wound in the same direction so as to form a single winding ($C_n$) presenting a pair of adjacent electrical terminations ($T_{1n}$, $T_{2n}$), the pairs of electrical terminations ($T_{1n}$, $T_{2n}$) of said windings ($C_n$) being connected to an acquisition system (7, 7') designed to produce a complete signal ($v_s$) which is an image of the primary current ($i_p$) of the transformer.

2. A current transformer according to claim 1, in which a pair of electrical terminations ($T_{1n}$, $T_{2n}$) of a partial circuit ($CB_n$) is disposed at one of two angular ends ($E_{1n}$, $E_{2n}$) of the partial circuit, the go and return windings ($C_{n0}$, $C_{n1}$) each extending along the angular extent ($\theta_n$) of the partial circuit ($CB_n$) and being electrically connected in series at the other angular end of said partial circuit.

3. A current transformer according to claim 1 or claim 2, in which each partial circuit ($CB_1$, $CB_2$, ..., $CB_N$) is made in the form of a plane or curved pcb having a series (31, 32) of metal tracks on each of its two faces, the tracks of one series (31) being electrically connected to the tracks of the other series (32) via plated-through holes (6) passing thorough said pcb to form the winding ($C_n$) of said partial circuit ($CB_n$).

4. A current transformer according to claim 3, in which said pcb comprises a substrate layer of constant thickness between the two series (31, 32) of metal tracks, a first half of the track in each series being used for the go winding ($C_{n0}$) while the other half is used for the return winding ($C_{n1}$) of the partial circuit.

5. A current transformer according to claim 1 or claim 2, in which each partial circuit ($CB_1$, $CB_2$, ..., $CB_N$) is made from two substrate boards (3, 4), each board having on each of its two faces one series (41, 42; 51, 52) of metal tracks, the tracks of one series (41; 51) on one plate being electrically connected with the tracks of the other series (42; 52) on the same plate via plated-through holes to form either a go winding ($C_{n0}$) or a return winding ($C_{n1}$) of said partial circuit ($CB_n$).

6.  A current transformer according to claim 4, in which each partial circuit ($CB_1$, $CB_2$, ..., $CB_N$) is in the form of an angular portion of a plane ring so as to form a complete ring circuit (CB), and each series (31, 32) of metal tracks of a pcb is made with tracks that are substantially rectilinear extending along radii which when extended pass through an axis (Z) perpendicular to the ring at its center (O).

7.  A current transformer according to claim 4, in which each pcb is in the form of an angular portion of a tubular ring whose axis of symmetry coincides with the axis (Z) of the primary conductor of the transformer, and in which the metal tracks of a printed circuit are parallel to said axis (Z) of the primary conductor.

8.  A current transformer according to claim 4, in which the complete circuit is mounted on a plane frame (15) having at least one primary conductor (10) of the transformer passing perpendicularly therethrough, and in which fasteners (16) having resilient return properties are provided for holding the adjacent angular ends of the pcbs against one another.

9.  A current transformer according to claim 6, taken in combination with claim 2, in which the complete ring circuit (CB) is made up of at least four identical partial circuits ($CB_1$, $CB_2$, $CB_3$, $CB_4$) whose faces (A, B) on one side of the ring alternate in pairs, so that one pair of electrical terminations ($T_{1n}$, $T_{2n}$) of the winding of a first partial circuit is disposed next to another pair of electrical terminations of one of the two partial circuits adjacent to said first partial circuit.

10. A current transformer according to any preceding claim, in which, for each partial circuit ($CB_n$), one of the two electrical terminations ($T_{1n}$, $T_{2n}$) of the winding is electrically connected to a common reference potential (G), while the other termination is electrically connected to an input ($E_n$) of an acquisition system (7, 7') having a summing and amplification function, and including at least one operational amplifier (8).

11. A current transformer according to claim 10, in which the partial circuits ($CB_n$) are identical, and each input ($E_n$) of the acquisition system (7, 7') is connected to an input (9) of said operational amplifier (8) via a resistor of resistance $R_1$ selected to satisfy the relationship:

$$R_1 = r_0\left(\frac{\beta}{\alpha_z} - 1\right)$$

where $\alpha_z$ is the temperature coefficient of the sensitivity ($s_n$) of the Rogowski coil formed by said winding ($C_n$), $\beta$ is the temperature coefficient of the resistivity of the material constituting the winding ($C_n$) of a partial circuit ($CB_n$), and $r_0$ is the internal resistance of said winding ($C_n$) at a given reference temperature ($T_0$); in such a manner that the signal from the complete circuit (CB), once amplified by the acquisition system (7, 7') is independent of variations in the temperature (T) of the transformer.

12. A current transformer according to claim 10 or claim 11, in which the voltage signals ($v_{s(n)}$) output by the partial circuits are summed in phase by the acquisition system (7, 7').

13. A current transformer according to any preceding claim, **characterized in that** it comprises a plurality (p) of complete circuits (CB) disposed mutually in parallel.

14. A current transformer according to claim 13 in combination with claim 11 or claim 12, in which the acquisition system (7) includes an amplifier circuit comprising an operational amplifier (8) having one input (9) connected to each of the partial circuits ($CB_n$) making up the complete circuits (CB).

15. A current transformer according to claim 13 in combination with claim 11 or claim 12, in which the acquisition system (7') comprises a first amplification stage (71, 72) comprising at least two operational amplifiers (8), the output from each amplifier (8) of said first stage being connected to a summing second stage provided for producing said complete signal ($v_s$).

**16.** A current transformer according to claim 15, in which the summing second stage comprises an operational amplifier (8') with a feedback loop for amplifying the sum of the signals produced by the amplifier first stage.

**Patentansprüche**

**1.** Stromwandler mit zumindest zwei Teilkreisen ($CB_1$, $CB_2$, ... $CB_n$ ..., $CB_N$), die jeweils eine Rogowski-Spule ($C_1$, $C_2$, ... $C_n$ ..., $C_N$) enthalten, wobei die Teilkreise jeweils in Form eines Winkelabschnitts eines Vollkreises (CB) ausgeführt sind, der über zumindest 360° einen Primärleiter (10, 10A, 10B, 10C) des Stromwandlers umgibt, wobei der Vollkreis für den Stromwandler die Funktion als Rogowski-Sekundärkreis hat, wobei die Wicklung ($C_n$) eines jeden Teilkreises ($CB_n$) aus einer Hinlaufwicklung ($C_{n0}$) sowie aus einer Rücklaufwicklung ($C_{n1}$) besteht, welche die Winkelerstreckung (θn) des Teilkreises ($CB_n$) durchlaufen, **dadurch gekennzeichnet, dass** für jeden Teilkreis ($CB_n$) die Hinlaufwicklung ($C_{n0}$) und die Rücklaufwicklung ($C_{n1}$) elektrisch in Reihe verbunden sind, wobei beide eine gleiche Windungswicklungsrichtung haben, um eine einzige Wicklung ($C_n$) zu bilden, die ein Paar von benach- barten elektrischen Abschlüssen ($T_{1n}$, $T_{2n}$) aufweist, wobei die Paare von elektrischen Abschlüssen ($T_{1n}$, $T_{2n}$) der Wicklungen ($C_n$) mit einem Erfassungssystem (7, 7') verbunden sind, das dazu vorgesehen ist, ein Signalgemisch ($v_s$) zu erzeugen, das ein Abbild des Primärstroms ($i_p$) des Stromwandlers ist.

**2.** Stromwandler nach Anspruch 1, wobei ein Paar von elektrischen Abschlüssen ($T_{1n}$, $T_{2n}$) eines Teilkreises ($CB_n$) an einem der beiden Winkelenden ($E_{1n}$, $E_{2n}$) des Teilkreises angeordnet ist, wobei die Hinlaufwicklung ($C_{n0}$) und die Rücklaufwicklung ($C_{n1}$) jeweils die Winkelerstreckung (θn) des Teilkreises ($CB_n$) durchlaufen, indem sie im Bereich des anderen Winkelendes des Teilkreises elektrisch in Reihe verbunden sind.

**3.** Stromwandler nach einem der Ansprüche 1 und 2, wobei jeder Teilkreis ($CB_1$, $CB_2$, ..., $CB_N$) aus einer flachen oder gekrümmten Leiterplatte gebildet ist, die an jeder ihrer beiden Seiten eine Reihe (31, 32) von Metallbahnen enthält, wobei die Bahnen einer Reihe (31) elektrisch mit denen der anderen Reihe (32) über durchkontaktierte Löcher (6) verbunden sind, welche die Platte durchsetzen, um die Wicklung ($C_n$) des Teilkreises ($CB_n$) zu bilden.

**4.** Stromwandler nach Anspruch 3, wobei die Leiterplatte eine Substratschicht mit konstanter Dicke enthält, welche zwei Reihen (31, 32) von Metallbahnen voneinander trennt, wobei eine erste Hälfte der Bahnen einer jeden Reihe für die Hinlaufwicklung ($C_{n0}$) verwendet wird, während die andere Hälfte für die Rücklaufwicklung ($C_{n1}$) des Teil- kreises verwendet wird.

**5.** Stromwandler nach einem der Ansprüche 1 und 2, wobei jeder Teilkreis ($CB_1$, $CB_2$, ..., $CB_N$) ausgehend von zwei Platten (3, 4) eines Substrats ausgebildet ist, wobei jede Platte auf jeder ihrer beiden Seiten eine Reihe (41, 42; 51, 52) von Metallbahnen enthält, wobei die Bahnen einer Reihe (41; 51) auf einer Platte elektrisch mit denen der anderen Reihe (42; 52) auf der gleichen Platte über durchkontaktierte Löcher verbunden sind, um entweder die Hinlaufwicklung ($C_{n0}$) oder die Rücklaufwicklung ($C_{n1}$) des Teilkreises ($CB_n$) zu bilden.

**6.** Stromwandler nach Anspruch 4, wobei jeder Teilkreis ($CB_1$, $CB_2$, ..., $CB_N$) die Form eines Winkelabschnitts eines flachen Rings aufweist, um einen ringförmigen Vollkreis (CB) zu bilden, und wobei jede Reihe von Metallbahnen (31, 32) einer gedruckten Schaltung mit im wesentlichen geradlinigen Bahnen gemäß Radien ausgebildet ist, deren Verlängerung durch eine Achse (Z) geht, die senkrecht zum Ring in seinem Mittelpunkt (0) verläuft.

**7.** Stromwandler nach Anspruch 4, wobei jede Leiterplatte die Form eines Winkelabschnitts eines rohrförmigen Rings aufweist, dessen Symmetrieachse mit der Achse (Z) des Primärleiters des Stromwandlers zusammenfällt und wobei die Metallbahnen einer gedruckten Schaltung parallel zur Achse (Z) des Primärleiters verlaufen.

**8.** Stromwandler nach Anspruch 4, wobei der Vollkreis an einem flachen Rahmen (15) montiert ist, der senkrecht von zumindest einem Primärleiter (10) des Stromwandlers durchsetzt wird, und wobei Verbinder (16) mit elastischen Rückstelleigenschaften vorgesehen sind, um die aneinandergrenzenden Winkelenden der gedruckten Schaltungen aneinandergefügt zu halten.

**9.** Stromwandler nach Anspruch 6 in Kombination mit Anspruch 2, wobei der ringförmige Vollkreis aus zumindest vier identischen Teilkreisen ($CB_1$, $CB_2$, $CB_3$, $CB_4$) gebildet ist, deren Flächen (A, B) einer gleichen Ringseite paarweise abwechseln, so dass ein Paar von elektrischen Abschlüssen ($T_{1n}$, $T_{2n}$) der Wicklung eines ersten Teilkreises neben einem weiteren Paar von elektrischen Abschlüssen eines der beiden Teilkreise angeordnet ist, die an den ersten Teilkreis angrenzen.

10. Stromwandler nach einem der vorangehenden Ansprüche, wobei für jeden Teilkreis (CBn) einer der beiden elektrischen Abschlüsse ($T_{1n}$, $T_{2n}$) der Wicklung elektrisch mit einem gemeinsamen Referenzpotential (G) verbunden ist, während der andere Abschluss elektrisch mit einem Eingang ($E_n$) eines Erfassungssystems (7, 7') verbunden ist, das eine Summierungs- und Verstärkungsfunktion hat, indem es zumindest einen Operationsverstärker (8) enthält.

11. Stromwandler nach Anspruch 10, wobei die Teilkreise ($CB_n$) identisch sind und jeder Eingang ($E_n$) des Erfassungssystems (7, 7') mit einem Eingang (9) des Operationsverstärkers (8) über einen Widerstand verbunden ist, dessen Wert $R_1$ so gewählt ist, dass gilt:

$$R_1 = r_0 \, (\beta/\alpha_z - 1)$$

wobei $\alpha_z$ der Temperaturkoeffizient der Empfindlichkeit ($s_n$) der Rogowski-Spule ist, die von der Wicklung ($C_n$) gebildet wird,
wobei $\beta$ der Temperaturkoeffizient der Resistivität des Materials ist, aus dem die Wicklung ($C_n$) eines Teilkreises ($CB_n$) besteht,
und $r_0$ der Innenwiderstand der Wicklung ($C_n$) bei einer gegebenen Referenztemperatur ($T_0$) ist,
so dass das Signal des Vollkreises (CB) nach Verstärkung durch das Erfassungssystem (7, 7') unabhängig von Schwankungen der Temperatur (T) des Stromwandlers ist.

12. Stromwandler nach einem der Ansprüche 10 und 11, wobei die Signale der Ausgangsspannungen ($v_{s(n)}$) der Teilkreise von dem Erfassungssystem (7, 7') in Phase summiert werden.

13. Stromwandler nach einem der vorangehenden Ansprüche, **dadurch gekennzeichnet, dass** er eine Mehrzahl (p) von Vollkreisen (CB) enthält, die parallel zueinander angeordnet sind.

14. Stromwandler nach Anspruch 13 in Kombination mit einem der Ansprüche 11 und 12, wobei das Erfassungssystem (7) eine Verstärkerschaltung enthält, die einen Operationsverstärker (8) enthält, von dem ein Eingang (9) mit jedem der Teilkreise ($C_{Bn}$) verbunden ist, welche die Vollkreise (CB) bilden.

15. Stromwandler nach Anspruch 13 in Kombination mit einem der Ansprüche 11 und 12, wobei das Erfassungssystem (7') eine erste Verstärkungsstufe (71, 72) enthält, die zumindest zwei Operationsverstärker (8) aufweist, wobei der Ausgang eines jeden Verstärkers (8) der ersten Stufe mit einer zweiten Summierungsstufe verbunden ist, um das genannte Signalgemisch ($v_s$) zu erzeugen.

16. Stromwandler nach Anspruch 15, wobei die zweite Summierungsstufe einen Operationsverstärker (8') mit einer Rückkopplungsschleife enthält, um eine Verstärkung der Summe der von der ersten Verstärkungsstufe erzeugen Signale durchzuführen.

FIG. 1

FIG. 1a

FIG. 1b

FIG. 2a

FIG. 2b

FIG. 2

FIG. 2c

FIG. 3

FIG. 4

FIG. 5

FIG. 5a

FIG. 6

FIG. 6a

## FIG. 7

## FIG. 8

21

## FIG. 9